# EUROPEAN PATENT APPLICATION

(11) **EP 4 391 041 A1**
(43) Date of publication of application: **26.06.2024**
(21) Application number: 23209981.2
(22) Date of filing: 15.11.2023
(51) Int. Cl.: H01L 21/8258, H01L 27/06, H01L 29/778, H01L 29/861, H01L 29/20, H01L 29/40

(54) **HIGH-ELECTRON-MOBILITY TRANSISTOR DEVICE WITH INTEGRATED P-N LAYER**

(30) Priority: 21.12.2022 US 202218069777
(71) Applicant: Analog Devices, Inc., Wilmington, MA 01887 (US)
(72) Inventor: FIORENZA, James, Wilmington, 01887 (US); PIEDRA, Daniel, Wilmington, 01887 (US)
(74) Representative: Horler, Philip John

(57) **Abstract**

Techniques to integrate a p-n diode in a substrate below a GaN HEMT, such as in a silicon carbide (SiC) substrate. The p-n diode provides avalanche robustness to the device and over voltage protection to the transistor.

## Description

### FIELD OF THE DISCLOSURE

This document pertains generally, but not by way of limitation, to semiconductor devices, and more particularly, to techniques for constructing gallium nitride devices.

### BACKGROUND

Gallium nitride (GaN) based semiconductors offer several advantages over other semiconductors as the material of choice for fabricating the next generation of transistors, or semiconductor devices, for use in both high voltage and high frequency applications. GaN based semiconductors, for example, have a wide bandgap that enable devices fabricated from these materials to have a high breakdown electric field and to be robust to a wide range of temperatures.

The two-dimensional electron gas (2DEG) channels formed by GaN based heterostructures generally have high electron mobility, making devices fabricated using these structures useful in power-switching and amplification systems. GaN based semiconductors, however, are typically used to fabricate depletion mode (or normally on) devices, which can have limited use in many of these systems, such as due to the added circuit complexity required to support such devices.

### SUMMARY OF THE DISCLOSURE

This disclosure describes techniques to integrate a p-n diode with a GaN HEMT, such as in a silicon carbide (SiC) substrate. The p-n diode provides avalanche robustness to the device and over voltage protection to the transistor.

In some aspects, this disclosure is directed to a compound semiconductor heterostructure transistor device comprising: a substrate; a dopant layer implanted in the substrate, wherein the dopant layer includes a p-type material forming a first region and an n-type material forming a second region, and wherein the first region is adjacent the second region; and a first semiconductor material layer formed over a second semiconductor material layer to form a compound semiconductor heterostructure having a two-dimensional electron gas (2DEG) channel, wherein the 2DEG channel is more electrically conductive than either the first semiconductor material layer or the second semiconductor material layer.

In some aspects, this disclosure is directed to a method of forming a compound semiconductor heterostructure transistor device, the method comprising: implanting a dopant layer in a substrate, wherein the dopant layer includes a p-type material forming a first region and an n-type material forming a second region, and wherein the first region is adjacent the second region; and forming a first semiconductor material layer over a second semiconductor material layer, wherein the second semiconductor material layer is formed over the substrate, to form a compound semiconductor heterostructure having a two-dimensional electron gas (2DEG) channel, wherein the 2DEG channel is more electrically conductive than either the first semiconductor material layer or the second semiconductor material layer.

In some aspects, this disclosure is directed to a compound semiconductor heterostructure transistor device comprising: a substrate; a dopant layer implanted in the substrate, wherein the dopant layer includes a p-type material forming a first region and an n-type material forming a second region, wherein the first region is adjacent the second region, and wherein the first region and the second region form a p-n junction diode; a nucleation layer formed over the dopant layer; and a first semiconductor material layer formed over a second semiconductor material layer to form a compound semiconductor heterostructure having a two-dimensional electron gas (2DEG) channel, wherein the 2DEG channel is more electrically conductive than either the first semiconductor material layer or the second semiconductor material layer, and wherein the second semiconductor material layer is formed over the nucleation layer.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
FIG. 1 depicts a cross-sectional diagram of an example of a compound semiconductor heterostructure transistor device that can implement various techniques of this disclosure.
FIG. 2 depicts a cross-sectional diagram of another example of a compound semiconductor heterostructure transistor device that can implement various techniques of this disclosure.
FIGS. 3A-3E depict an example of a process flow for fabricating a HEMT device having a dopant layer implanted in a substrate, in accordance with this disclosure.
FIG. 4 is an example of a flow diagram of a method of forming a compound semiconductor heterostructure transistor device, in accordance with various techniques of this disclosure.

### DETAILED DESCRIPTION

Many silicon-based transistors, such as field-effect transistors (FETs), have built-in body diodes as a product of the fabrication process. An n-type or a p-type dopant material can be included in the body of the transistor by patterning and implanting the dopant material into the silicon itself.

The present inventors have recognized the desirability of including diodes in high-electron-mobility transistor (HEMT) devices, such as those using gallium nitride (GaN) based compound semiconductor materials, to provide avalanche robustness to the device as well as overvoltage protection. Most GaN transistors do not have a built-in body diode. Instead, a separate diode is formed and then connected to a transistor.

Unlike silicon, GaN is difficult to implant with an n-type or a p-type dopant material. For example, when attempting to implant dopant materials in GaN, the activation efficiency for dopants in a wide bandgap material like GaN is poor. As a consequence, it is necessary to implant a very high dose of the dopant material to get a lot of the p-type or n-type atoms into the GaN. Then, the doped GaN should be annealed at a very high temp to activate the dopants, which can be so high as to damage or degrade the GaN. After the high temperature anneal, the percentage of dopants activated is very small and likely not sufficient to create a built-in diode.

This disclosure describes techniques to integrate a p-n diode with a GaN HEMT, such as in a silicon carbide (SiC) substrate. The p-n diode provides avalanche robustness to the device and over voltage protection to the transistor.

As used in this disclosure, a GaN-based compound semiconductor material can include a chemical compound of elements including GaN and one or more elements from different groups in the periodic table. Such chemical compounds can include a pairing of elements from group 13 (i.e., the group comprising boron (B), aluminum (Al), gallium (Ga), indium (In), and thallium (Tl)) with elements from group 15 (i.e., the group comprising nitrogen (N), phosphorus (P), arsenic (As), antimony (Sb), and bismuth (Bi)). Group 13 of the periodic table can also be referred to as Group III and group 15 as Group V. In an example, a semiconductor device can be fabricated from GaN and aluminum indium gallium nitride (AlInGaN).

Heterostructures described herein can be formed as AlN / GaN / AlN heterostructures, InAlN / GaN heterostructures, AlGaN/GaN heterostructures, or heterostructures formed from other combinations of group 13 and group 15 elements. These heterostructures can form a two-dimensional electron gas (2DEG) at the interface of the compound semiconductors that form the heterostructure, such as the interface of GaN and AlGaN. The 2DEG can form a conductive channel of electrons that can be controllably depleted, such as by an electric field formed by a buried layer of p-type material disposed below the channel. The conductive channel of electrons that can also be controllably enhanced, such as by an electric field formed by a gate terminal disposed above the channel to control a current through the semiconductor device. Semiconductor devices formed using such conductive channels can include high electron mobility transistors.

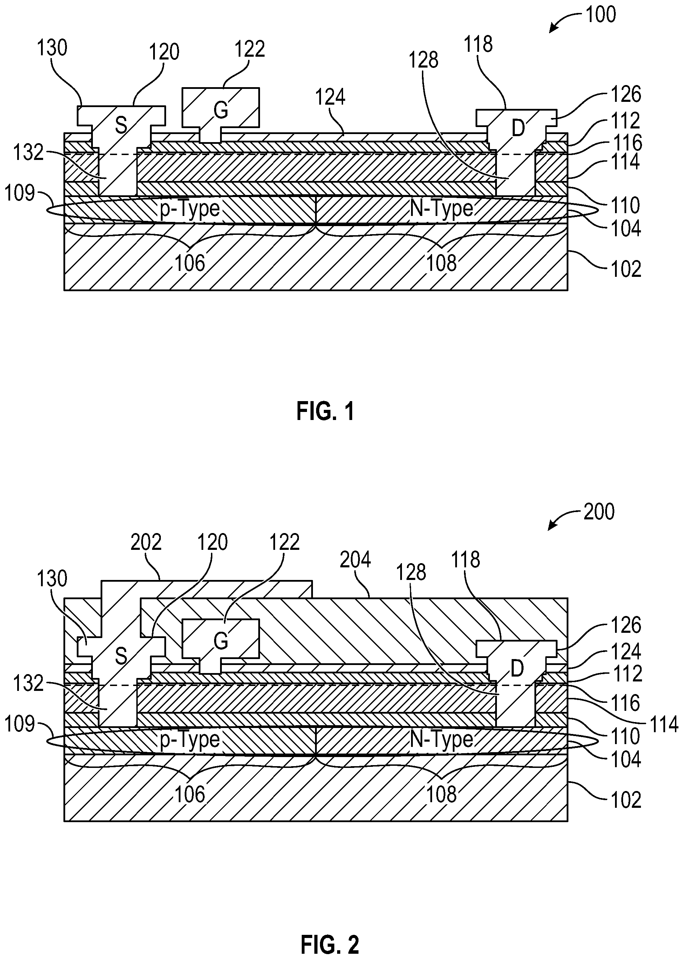

FIG. 1 depicts a cross-sectional diagram of an example of a compound semiconductor heterostructure transistor device 100 that can implement various techniques of this disclosure. The compound semiconductor heterostructure transistor device 100, e.g., GaN HEMT, includes a substrate 102, such as silicon carbide (SiC) or sapphire. In accordance with this disclosure, a dopant layer 104 is implanted in the substrate 102. The dopant layer 104 includes a p-type material forming a first region 106 and an n-type material forming a second region 108, where the first region 106 is adjacent the second region 108. For example, a silicon carbide (SiC) substrate 102 is patterned and implanted with a p-type dopant material and an n-type dopant material. In some examples, the first region 106 and the second region 108 forms a p-n junction diode 109, like a body diode in silicon-based transistor. Examples of p-type dopant materials include aluminum and boron and examples of n-type dopant materials include nitrogen and phosphorus.

The compound semiconductor heterostructure transistor device 100 can optionally include a nucleation layer 110, such as aluminum nitride (AlN), formed over the substrate 102, such as directly above the dopant layer 104. The nucleation layer 110 can provide a transition between the dopant layer 104 and a GaN layer or aluminum gallium nitride (AlGaN) layer.

The compound semiconductor heterostructure transistor device 100 includes a first semiconductor material layer 112, such as AlGaN, formed over a second semiconductor material layer 114, such as GaN, to form a compound semiconductor heterostructure having a two-dimensional electron gas (2DEG) channel 116 (represented by a dashed line). The 2DEG channel 116 is more electrically conductive than either the first semiconductor material layer 112 or the second semiconductor material layer 114.

A drain electrode 118 is electrically coupled to the second region 108 of the dopant layer 104 and to the 2DEG channel 116. A source electrode 120 is electrically coupled to the first region 106 of the dopant layer 104 and to the 2DEG channel 116. A gate electrode 122 is formed over first semiconductor material layer 112. In some examples, the compound semiconductor heterostructure transistor device 100 includes a passivation layer 124, such as silicon nitride (SiN) or silicon oxide, formed over the first semiconductor material layer 112. In this disclosure, "formed over" includes being formed directly over as well as being formed over with intervening materials or layers.

A first portion 126 of the drain electrode 118 includes a first material and a second portion 128 includes a second material. In some examples, the first material is different from the second material. For example, the first material, e.g., aluminum, of the first portion 126 can make good electrical contact with the second semiconductor material layer 114, such as GaN, or good electrical contact with the AlGaN/GaN interface where the 2DEG channel 116 is formed, and the second material, such as titanium or aluminum, of the second portion 128 can make good electrical contact with the n-type second region 108 of the SiC substrate 102.

For example, vias can be etched through the second semiconductor material layer 114, e.g., GaN, and then a thin layer of the second material, e.g., titanium or aluminum, can be formed adjacent the n-type material of the second region 108. Next, the remaining part of the via (forming the first portion 126) can be filled with the first material, e.g., aluminum.

A first portion 130 of the source electrode 120 includes a first material and a second portion 132 includes a second material. In some examples, where the first material is different from the second material. For example, the first material of the first portion 130 can make good electrical contact with the first semiconductor material layer 112, such as AlGaN, and the second material, such as nickel, of the second portion 132 can make good electrical contact with the p-type first region 106 of the SiC substrate 102.

For example, vias can be etched through the second semiconductor material layer 114, e.g., GaN, and then a thin layer of the second material, e.g., nickel, can be formed adjacent the p-type material of the first region 106. Next, the remaining part of the via (forming the first portion 130) can be filled with the first material, e.g., aluminum.

FIG. 2 depicts a cross-sectional diagram of another example of a compound semiconductor heterostructure transistor device 200 that can implement various techniques of this disclosure. Some of the features of the compound semiconductor heterostructure transistor device 200 are similar to features of the compound semiconductor heterostructure transistor device 100 of FIG. 1 and, as such, use similar reference numbers. For purposes of conciseness, similar features will not be described in detail again.

The compound semiconductor heterostructure transistor device 200, e.g., GaN HEMT, further includes a field plate 202 formed over the first semiconductor material layer 112. The field plate 202 can control the electric field at the surface of the compound semiconductor heterostructure transistor device 200, such as the electric field between the gate and drain, or the electric field between the source and drain. In the example shown, the field plate 202 is formed over a passivation layer 204, e.g., silicon nitride or silicon oxide.

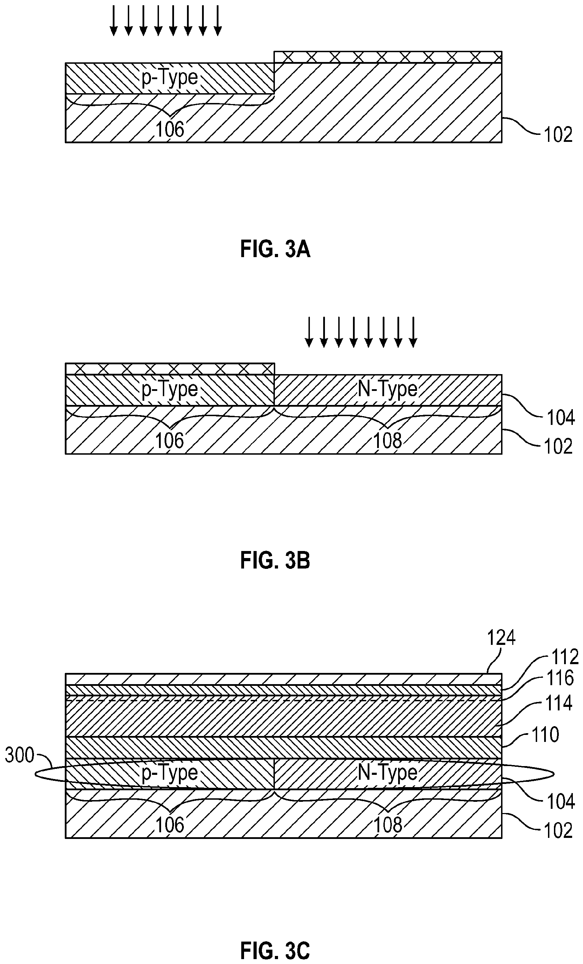

FIGS. 3A-3E depict an example of a process flow for fabricating a HEMT device having a dopant layer implanted in a substrate, in accordance with this disclosure. In FIG. 3A, a substrate 102 is patterned and implanted with a p-type dopant material to form the first region 106.

In FIG. 3B, the substrate 102 is patterned and implanted with an n-type dopant material to form the second region 108, such as to form a p-n junction diode 300.

In FIG. 3C, a semiconductor material layer 114, e.g., GaN, is formed over the substrate 102. For example, a GaN layer can be epitaxially grown, such as over a nucleation layer 110. Then, another semiconductor material layer 112 is formed over the semiconductor material layer 114. For example, an AlGaN layer can be epitaxially grown, such as over the second semiconductor material layer 114 to form a compound semiconductor heterostructure having a 2DEG channel 116. The 2DEG channel 116 is more conductive than either the semiconductor material layer 114 or the semiconductor material layer 112. In the example shown, a passivation layer 124 is formed over the semiconductor material layer 112.

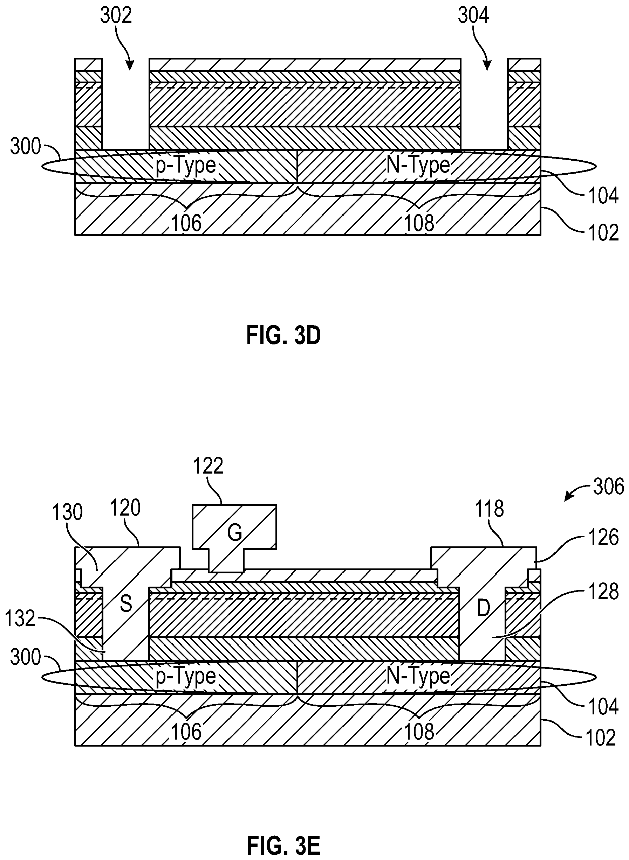

In FIG. 3D, prior to ohmic metal deposition, vias 302, 304 are etched under the AlGaN/GaN HEMT source and drain electrodes to the first region 106 and the second region 108, respectively, of the substrate 102. The vias 302, 304 will contact the p-type material and the n-type material, e.g., of the p-n junction diode 300, of the substrate, e.g., SiC. A p-n junction diode provides avalanche robustness to the device and over voltage protection.

In FIG. 3E, ohmic contacts are deposited to form the drain electrode 118 and the source electrode 120. The gate electrode 122, e.g., a T-gate electrode, is formed. In this manner, a compound semiconductor heterostructure transistor device 306 is formed, which is similar to the compound semiconductor heterostructure transistor device 100 of FIG. 1.

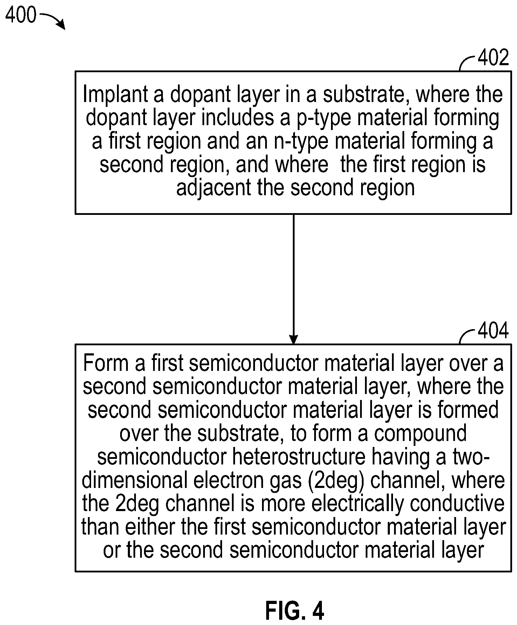

FIG. 4 is an example of a flow diagram of a method 400 of forming a compound semiconductor heterostructure transistor device, in accordance with various techniques of this disclosure. At block 402, the method 400 includes implanting a dopant layer implanted in a substrate, wherein the dopant layer includes a p-type material forming a first region and an n-type material forming a second region, and wherein the first region is adjacent the second region. For example, a p-type material can be implanted in a first region 106 of FIG. 1 and an n-type material can be implanted in a second region 108 of FIG. 1.

At block 404, the method 400 includes forming a first semiconductor material layer over a second semiconductor material layer, wherein the second semiconductor material layer is formed over the substrate, to form a compound semiconductor heterostructure having a two-dimensional electron gas (2DEG) channel, where the 2DEG channel is more electrically conductive than either the first semiconductor material layer or the second semiconductor material layer. For example, an AlGaN layer 112 of FIG. 1 can be formed over a GaN layer 114 of FIG. 1, where the GaN layer is formed over the substrate 102, to form a compound semiconductor heterostructure having a 2DEG channel 116. The 2DEG channel 116 is more electrically conductive than either the AlGaN layer 112 or the GaN layer 114.

In some examples, the method 400 includes etching vias to the first region and the second region.

In some examples, the method 400 includes electrically coupling a gate electrode with the first semiconductor material layer, electrically coupling a source electrode with the first region of the dopant layer, and electrically coupling a drain electrode with the second region of the dopant layer.

In some examples, the method 400 includes forming the source electrode of a first material and a second material, where the first material is different from the second material. In some examples, the first material includes nickel.

In some examples, the method 400 includes forming the drain electrode of a first material and a second material, where the first material is different from the second material. In some examples, the second material includes titanium or aluminum.

In some examples, the method 400 includes forming a field plate over the first semiconductor material layer.

### ASPECTS OF THE DISCLOSURE

Non-limiting aspects of the disclosure are set out in the following numbered clauses.
1. A compound semiconductor heterostructure transistor device comprising:
   a substrate;
   a dopant layer implanted in the substrate, wherein the dopant layer includes a p-type material forming a first region and an n-type material forming a second region, and wherein the first region is adjacent the second region; and
   a first semiconductor material layer formed over a second semiconductor material layer to form a compound semiconductor heterostructure having a two-dimensional electron gas (2DEG) channel, wherein the 2DEG channel is more electrically conductive than either the first semiconductor material layer or the second semiconductor material layer.
2. The compound semiconductor heterostructure transistor device of clause 1, wherein the substrate includes silicon carbide.
3. The compound semiconductor heterostructure transistor device of any preceding clause, comprising:
   a gate electrode electrically coupled with the first semiconductor material layer;
   a source electrode electrically coupled with the first region of the dopant layer and to the 2DEG channel; and
   a drain electrode electrically coupled with the second region of the dopant layer and to the 2DEG channel.
4. The compound semiconductor heterostructure transistor device of clause 3, wherein the source electrode includes a first material and a second material, wherein the first material is different from the second material.
5. The compound semiconductor heterostructure transistor device of clause 4, wherein the first material includes nickel.
6. The compound semiconductor heterostructure transistor device of any of clauses 3 to 5,
   wherein the drain electrode includes a first material and a second material, wherein the first material is different from the second material.
7. The compound semiconductor heterostructure transistor device of clause 6, wherein the second material includes titanium or aluminum.
8. The compound semiconductor heterostructure transistor device of any of clauses 3 to 7, comprising:
   a field plate formed over the first semiconductor material layer.
9. The compound semiconductor heterostructure transistor device of any preceding clause, wherein the first region and the second region form a p-n junction diode.
10. A method of forming a compound semiconductor heterostructure transistor device, the method comprising:
   implanting a dopant layer in a substrate, wherein the dopant layer includes a p-type material forming a first region and an n-type material forming a second region, and wherein the first region is adjacent the second region; and
   forming a first semiconductor material layer over a second semiconductor material layer, wherein the second semiconductor material layer is formed over the substrate, to form a compound semiconductor heterostructure having a two-dimensional electron gas (2DEG) channel, wherein the 2DEG channel is more electrically conductive than either the first semiconductor material layer or the second semiconductor material layer.
11. The method of clause 10, comprising:
   etching vias to the first region and the second region.
12. The method of clause 10 or clause 11, comprising:
   electrically coupling a gate electrode with the first semiconductor material layer;
   electrically coupling a source electrode with the first region of the dopant layer and to the 2DEG channel; and
   electrically coupling a drain electrode with the second region of the dopant layer and to the 2DEG channel.
13. The method of clause 12, comprising:
   forming the source electrode of a first material and a second material, wherein the first material is different from the second material.
14. The method of clause 13, wherein the first material includes nickel.
15. The method of any of clauses 12 to 14, comprising:
   forming the drain electrode of a first material and a second material, wherein the first material is different from the second material.
16. The method of clause 15, wherein the second material includes titanium or aluminum.
17. The method of any of clauses 10 to 16, comprising:
   forming a field plate over the first semiconductor material layer.
18. A compound semiconductor heterostructure transistor device comprising:
   a substrate;
   a dopant layer implanted in the substrate, wherein the dopant layer includes a p-type material forming a first region and an n-type material forming a second region, wherein the first region is adjacent the second region, and wherein the first region and the second region form a p-n junction diode;
   a nucleation layer formed over the dopant layer; and
   a first semiconductor material layer formed over a second semiconductor material layer to form a compound semiconductor heterostructure having a two-dimensional electron gas (2DEG) channel, wherein the 2DEG channel is more electrically conductive than either the first semiconductor material layer or the second semiconductor material layer, and wherein the second semiconductor material layer is formed over the nucleation layer.
19. The compound semiconductor heterostructure transistor device of clause 18, comprising:
   a field plate formed over the first semiconductor material layer.
20. The compound semiconductor heterostructure transistor device of clause 18 or clause 19, wherein the substrate includes silicon carbide.

### Various Notes

Each of the non-limiting aspects or examples described herein may stand on its own or may be combined in various permutations or combinations with one or more of the other examples.

The above detailed description includes references to the accompanying drawings, which form a part of the detailed description. The drawings show, by way of illustration, specific embodiments in which the invention may be practiced. These embodiments are also referred to herein as "examples." Such examples may include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following aspects, the terms "including" and "comprising" are open-ended, that is, a system, device, article, composition, formulation, or process that includes elements in addition to those listed after such a term in an aspect are still deemed to fall within the scope of that aspect. Moreover, in the following aspects, the terms "first," "second," and "third," etc. are used merely as labels, and are not intended to impose numerical requirements on their objects.

Method examples described herein may be machine or computer-implemented at least in part. Some examples may include a computer-readable medium or machine-readable medium encoded with instructions operable to configure an electronic device to perform methods as described in the above examples. An implementation of such methods may include code, such as microcode, assembly language code, a higher-level language code, or the like. Such code may include computer readable instructions for performing various methods. The code may form portions of computer program products. Further, in an example, the code may be tangibly stored on one or more volatile, non-transitory, or nonvolatile tangible computer-readable media, such as during execution or at other times. Examples of these tangible computer-readable media may include, but are not limited to, hard disks, removable magnetic disks, removable optical disks (e.g., compact discs and digital video discs), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other embodiments may be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the aspects. Also, in the above Detailed Description, various features may be grouped together to streamline the disclosure. This should not be interpreted as intending that an unclaimed disclosed feature is essential to any aspect. Rather, inventive subject matter may lie in less than all features of a particular disclosed embodiment. Thus, the following aspects are hereby incorporated into the Detailed Description as examples or embodiments, with each aspect standing on its own as a separate embodiment, and it is contemplated that such embodiments may be combined with each other in various combinations or permutations. The scope of the invention should be determined with reference to the appended aspects, along with the full scope of equivalents to which such aspects are entitled.

## Claims

1. A compound semiconductor heterostructure transistor device comprising:
a substrate;
a dopant layer implanted in the substrate, wherein the dopant layer includes a p-type material forming a first region and an n-type material forming a second region, and wherein the first region is adjacent the second region; and
a first semiconductor material layer formed over a second semiconductor material layer to form a compound semiconductor heterostructure having a two-dimensional electron gas (2DEG) channel, wherein the 2DEG channel is more electrically conductive than either the first semiconductor material layer or the second semiconductor material layer.

2. The compound semiconductor heterostructure transistor device of claim 1, wherein the substrate includes silicon carbide.

3. The compound semiconductor heterostructure transistor device of any preceding claim, comprising:
a gate electrode electrically coupled with the first semiconductor material layer;
a source electrode electrically coupled with the first region of the dopant layer and to the 2DEG channel; and
a drain electrode electrically coupled with the second region of the dopant layer and to the 2DEG channel.

4. The compound semiconductor heterostructure transistor device of claim 3, wherein the source electrode includes a first material and a second material, wherein the first material is different from the second material.

5. The compound semiconductor heterostructure transistor device of claim 4, wherein the first material includes nickel.

6. The compound semiconductor heterostructure transistor device of any of claims 3 to 5,
wherein the drain electrode includes a first material and a second material, wherein the first material is different from the second material.

7. The compound semiconductor heterostructure transistor device of claim 6, wherein the second material includes titanium or aluminum.

8. The compound semiconductor heterostructure transistor device of any of claims 3 to 7, comprising:
a field plate formed over the first semiconductor material layer.

9. The compound semiconductor heterostructure transistor device of any preceding claim, wherein the first region and the second region form a p-n junction diode.

10. A method of forming a compound semiconductor heterostructure transistor device, the method comprising:
implanting a dopant layer in a substrate, wherein the dopant layer includes a p-type material forming a first region and an n-type material forming a second region, and wherein the first region is adjacent the second region; and
forming a first semiconductor material layer over a second semiconductor material layer, wherein the second semiconductor material layer is formed over the substrate, to form a compound semiconductor heterostructure having a two-dimensional electron gas (2DEG) channel, wherein the 2DEG channel is more electrically conductive than either the first semiconductor material layer or the second semiconductor material layer.

11. The method of claim 10, comprising:
etching vias to the first region and the second region.

12. The method of claim 10 or claim 11, comprising:
electrically coupling a gate electrode with the first semiconductor material layer;
electrically coupling a source electrode with the first region of the dopant layer and to the 2DEG channel; and
electrically coupling a drain electrode with the second region of the dopant layer and to the 2DEG channel.

13. The method of claim 12, comprising:
forming the source electrode of a first material and a second material, wherein the first material is different from the second material;
and optionally wherein the first material includes nickel.

14. The method of any of claims 12 to 13, comprising:
forming the drain electrode of a first material and a second material, wherein the first material is different from the second material;
and optionally wherein the second material includes titanium or aluminum.

15. The method of any of claims 10 to 14, comprising:
forming a field plate over the first semiconductor material layer.
